Europäisches Patentamt

European Patent Office

Office européen des brevets

(11) Numéro de publication: **0 211 716**
**A1**

(12) **DEMANDE DE BREVET EUROPEEN**

(21) Numéro de dépôt: **86401457.6**

(22) Date de dépôt: **01.07.86**

(51) Int. Cl.4: **H01L 23/48** , H01L 21/60

(30) Priorité: **12.07.85 FR 8510719**

(43) Date de publication de la demande:
**25.02.87 Bulletin 87/09**

(84) Etats contractants désignés:
**AT CH DE FR GB LI**

(71) Demandeur: **EUROTECHNIQUE**
**ZI de Peynier-Rousset**
**F-13 790 - Rousset(FR)**

(72) Inventeur: **Gloton, Jean-Pierre**
**THOMSON-CSF SCPI 19, avenue de Messine**
**F-75008 Paris(FR)**
Inventeur: **Peres, Philippe**
**THOMSON-CSF SCPI 19, avenue de Messine**
**F-75008 Paris(FR)**

(74) Mandataire: **Guérin, Michel et al**
**THOMSON-CSF SCPI 19, avenue de Messine**
**F-75008 Paris(FR)**

(54) **Procédé de fabrication en continu de micromodules pour cartes contenant des composants, bande continue de micromodules, et micromodule réalisé selon un tel procédé.**

(57) L'invention trouve application notamment dans les cartes contenant des composants de type CCC pour le paiement électronique ou les cartes de sécurité.

Selon l'invention une bande continue conductrice est constituée, sur laquelle est déssinée une série de cellules conductrices (29, 30) constituées d'une part de contacts (C1-C8) et d'une plage centrale (S1) sur laquelle sera déposé un microcircuit. Puis une capsule de résine protectrice (31) sera disposée sur la face portant le microcircuit. Des découpes de la bande continue permettent de prélever un micromodule terminé. Sur la face externe de la bande est disposé un film plastique protecteur des contacts qui évite aussi que de la résine passe sur la face des contacts destinés à être en contact avec un lecteur de cartes CCC.

**FIG_1**

Xerox Copy Centre

**PROCEDE DE FABRICATION EN CONTINU DE MICROMODULES POUR CARTES CONTENANT DES COMPOSANTS, BANDE CONTINUE DE MICROMODULES ET MICROMODULES REALISES SELON UN TEL PROCEDE**

La présente invention concerne un procédé de fabrication en continu de micromodules pour cartes contenant des composants de type CCC. Elle concerne aussi en tant que produits obtenus selon un tel procédé, une bande continue de micromodules et un micromodule. Elle trouve l'application dans le domaine de la fabrication de composants notamment pour les cartes de type paiement électronique ou encore cartes de sécurité.

L'invention présente la caractéristique de transposer dans le domaine de la fabrication du micromodule les procédés de fabrication sur film cinéma déjà développés dans d'autres domaines. La transposition de ces procédés, dans le domaine des micromodules pour cartes CCC amène des modifications tant au niveau du procédé que des produits obtenus par ces procédés.

On sait qu'au niveau de la fabrication de tels composants de grandes quantités sont prévues pour chaque série. Les réductions de coûts de fabrication par unité sont donc de la plus haute importance.

Dans l'art antérieur on sait fabriquer des micromodules composant essentiel d'une carte de type CCC. Une telle carte comporte au moins un micromodule monté à l'intérieur d'un support plastique figurant la carte elle-même. Le micromodule comporte en règle général un microcircuit disposé sur des plages conductrices qui réalisent une connexion des sorties du microcircuit vers des contacts destinés à être lus par un lecteur de cartes CCC. Des fils de connexion sont donc amenés de chaque sortie du microcircuit à une zone de contact prédéterminée. L'ensemble est disposé dans une capsule en résine qui permet de protéger le micromodule et de lui donner une certaine rigidité mécanique.

La présente invention concerne un procédé de fabrication en continu de micromodules pour cartes contenant des composants CCC. Elle se caractérise notamment en ce que le procédé consiste :

-à découper sur une bande métallique continue des cellules conductrices successives, chaque cellule étant retenue à la bande par des parties métalliques étroites, notamment au niveau des contacts,

-à déposer un film plastique sur une première face de la bande conductrice ;

- à fixer sur une plage centrale conductrice de chaque cellule, sur une deuxième face, au moins un microcircuit relié aux contacts par des fils conducteurs ;

-à déposer sur la deuxième face de la bande conductrice, au moins localement au-dessus du microcircuit, une résine de protection ;

- à séparer par découpe chaque micromodule de ses voisins.

L'invention concerne aussi une bande continue de micromodules réalisée selon le procédé de l'invention. Une telle bande comporte une première couche 1 constituée par un film plastique de protection des contacts des micromodules assemblés, une seconde couche conductrice qui constitue une cellule conductrice de contacts pour chaque micromodule et les éléments de retenue de chaque micromodule à ces voisins, une troisième couche constituée par une résine de protection, au moins un microcircuit ayant été disposé sur chaque cellule avec des fils de connexions aux contacts avant dépôt de la troisième couche.

L'invention concerne aussi un micromodule découpé dans une bande de micromodules selon l'invention. Un tel micromodule comporte un film plastique protecteur 1 détachable au moins localement au droit des contacts, une cellule conductrice constituant les contacts et un support d'au moins un microcircuit relié par des fils de connexion électrique aux contacts et une capsule de résine recouvrant au moins partiellement la face de la cellule qui porte le microcircuit.

D'autres caractéristiques et avantages de la présente invention apparaitront à l'aide de la description et des figures annexées qui sont :

-la figure 1 : un schéma d'un micromodule selon l'invention,

-la figure 2 : une partie d'une bande continue constituée selon l'invention,

-la figure 3 : une variante de réalisation selon l'invention.

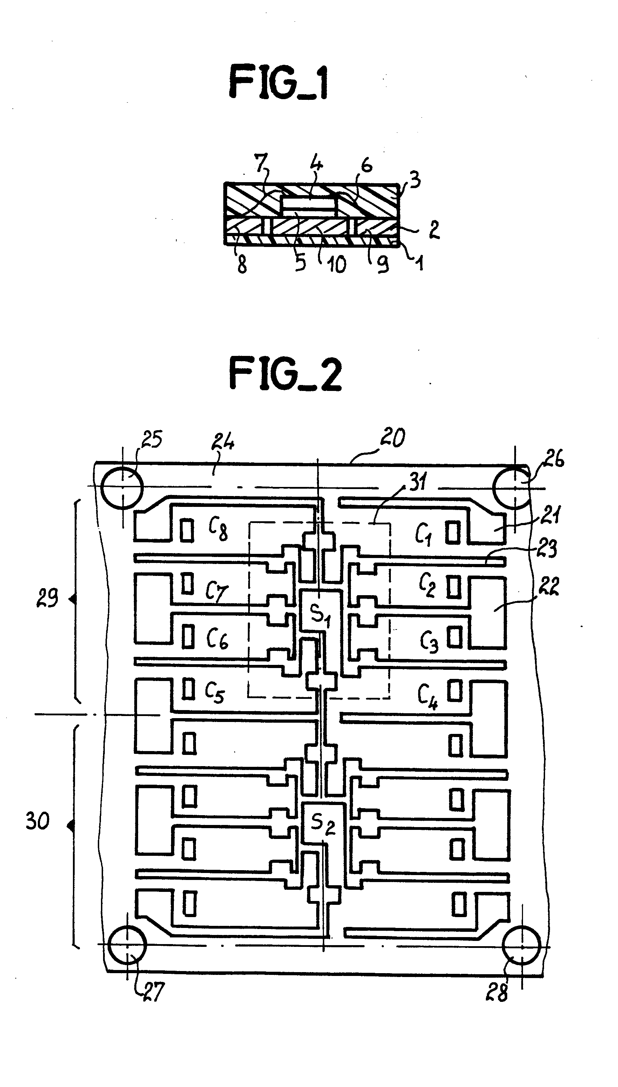

A la figure 1 on a représenté un micromodule 1 selon l'invention. Un tel micromodule comporte trois couches successives. Une première couche 1 est constituée par un film plastique de protection des contacts du micromodule. Une seconde couche 2 est constituée par une cellule conductrice composée de contacts comme les contacts 8 et 9 et d'une plage conductrice 10 centrale.

Sur la plage conductrice 10 centrale, on dépose un microcircuit 4 comme une mémoire morte. Dans un exemple de réalisation la mémoire morte 4 est fixée à la plage 10 par une couche de colle conductrice 5. Des fils de connexion comme les fils 6, 7 réalisent la connexion électrique de sorties de la mémoire aux contacts 8, 9. Enfin une troisième couche 3 constituée par une résine de protection enrobe la face supérieure du micromodule aux dessins.

Afin de permettre l'utilisation du micromodule par exemple dans une carte de type CCC, le film plastique de protection 1 est retiré de la face arrière dure de la cellule conductrice 2. Dans un mode de réalisation non représentée aux dessins les seules parties du film protecteur 1 qui soient retirées sont les parties du film au droit des contacts 8, 9. Une telle réalisation permet de conserver une protection superficielle des parties conductrices sur la face inférieure du micromodule aux dessins.

Dans un exemple de réalisation l'épaisseur d'un tel micromodule est limitée à 600 microns d'épaisseur. La cellule conductrice est constituée par un ruban métallique de 100 microns d'épaisseur. On dispose 20 microns de colle conductrice puis 275 microns pour la mémoire morte. Les fils conducteurs étant de l'ordre de 25 microns de diamètre il est prévu 50 microns pour constituer leur courbure au retour sur les contacts de la cellule conductrice. 130 microns de résine sont conservés par meulage.

A la figure 2, on va expliquer comment le procédé de l'invention est mis en oeuvre dans un exemple de réalisation particulier. A la figure 2 une bande continue 20 est présentée partiellement dans le sens de la longueur. Des moyens d'indexation 25-28 constitués ici par des perçages circulaires permettent d'identifier la période de un pas sur la bande qui correspond à une cellule conductrice. A la figure 2, afin de doubler le rendement du procédé et d'après les dimensions admises par la normalisation des micromodules, deux micromodules 29, 30 peuvent être fabriqués en parallèle. De part et d'autres du dessin et non représenté à la figure 2 les voisins des micromodules 29, 30 sont dessinés de manière identique. A la figure 2 on a détaillé principalement le micromodule supérieur. Huit contacts sont prévus C1-C8 constitués par une découpe convenable de la bande continue 24. Une telle découpe peut être réalisée ou bien par estampage ou bien par photogravure. En particulier dans le cas de la photogravure, la bande continue 1 est constituée par un film plastique dont une face est métallisée.

Le micromodule fabriqué sur la cellule 29, comporte une plage conductrice centrale S1 directement en relation avec le contact C4. Sur cette plage centrale S1 sera disposé ainsi qu'il est visible à la figure 1 pour la plage 10, un microcircuit comme le microcircuit 4. Le micromodule qui sera constitué sur la cellule semiconductrice 29 est relié d'une part à la bande continu 20 par des parties latérales non repérées aux dessins et par des parties étroites comme la partie 23 obtenue par des découpes comme les découpes 21 ou 22 dans la bande conductrice.

Dans le procédé selon l'invention on dépose ensuite le microcircuit sur la plage S1, on dispose les fils de connexion par soudage notamment par ultrasons puis on enrobe au moins partiellement dansla zone 31 le microcircuit sur la cellule conductrice 29 avec une résine de protection.

L'opération est identique sur un pas donné sur la cellule conductrice 30. Elle est répétée à chaque pas quand la bande est déplacée sur une machine utilisant les moyens d'indexation.

Selon l'invention le micromodule est obtenu à partir de la bande par une découpe des parties étroites de liaison des micromodules entre eux. Quand la résine protectrice recouvre de manière continue l'ensemble de la bande la découpe est réalisés tranversalement à l'axe de la bande continue au droit des découpes comme les découpes 21 et 22. De plus des découpes longitudinales audessus des contacts C1 et C8 du module 29 et endessous des contacts réciproques C4, C5 de la cellule 30 sont réalisés pour permettre d'extraire chacun des micromodules de la bande continue.

La bande de protection 1 disposée sur la face inférieure peut être otée ou bien à l'installation du micromodule dans son produit fini ou bien après la constitution de la bande continue du micromodule. Son rôle peut se limiter à un rôle de protection de contact pendant la fabrication des micromodules pour éviter que la résine notamment ne passe de la deuxième face de la cellule conductrice sur laquelle est déposée le microcircuit vers la première face sur laquelle les contacts seront lus.

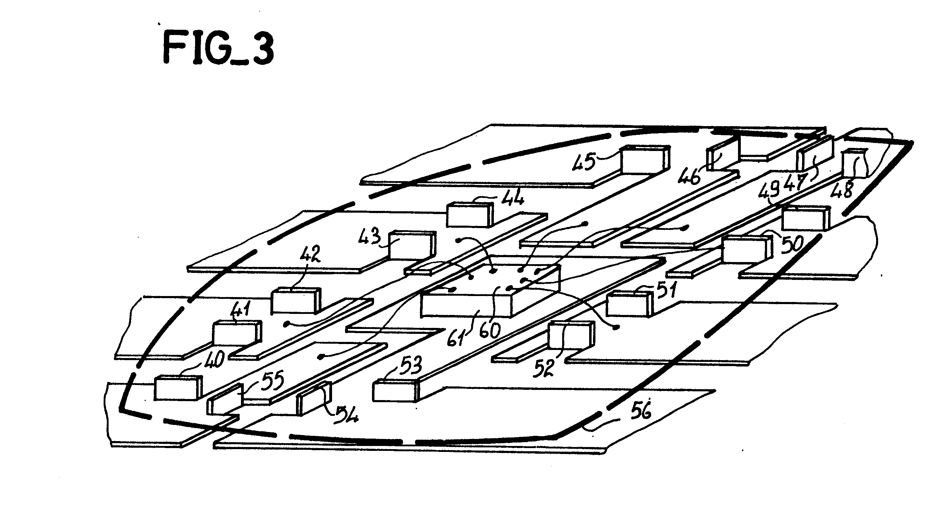

A la figure 3 on a représenté une vue d'une variante d'exécution sur l'invention. Sur la bande, les différents contacts C1 à C8 sont représentés partiellement de part et d'autres d'une zone centrale conductrice. Le microcircuit 60 est disposé sur une couche de colle 61. Les fils de connexion du microcircuit aux différents contacts sont représentés à la figure. De même une zone 56 de dépose de la résine de protection qui constitura la capsule de protection du micromodule est représenté.

Selon cette variante des volets 40-55 sont prévus sur chaque contacts tournés vers l'intérieur de la capsule de résine de manière à augmenter l'adhérence de la résine sur la cellule conductrice. Selon la nature de la résine, différentes orientations des volets peuvent être prévus. En particulier les volets peuvent formés un angle aigu relativement au plan de la cellule conductrice. Aux dessins et selon un mode préféré de réalisation les volets sont tous disposés dans une direction perpendiculaire au plan de la cellule conductrice.

En variante, les bandes continues peuvent comporter d'autres moyens d'indexation que ceux représentés à la figure 2. En particulier, ceux-ci peuvent être disposés sous forme de fentes au début et à la fin de chaque bande.

Dans un mode de réalisation préféré, avant l'opération de dépôt de la résine de protection, on réalise un dépôt d'un film conducteur qui protège la deuxième face du ruban métallique des agent chimiques. On choisit l'Or.

**Revendications**

1. Procédé de fabrication en continu de micromodules pour cartes contenant des composants CCC, un micromodule comportant au moins un microcircuit disposé sur une cellule conductrice constituée de contacts et protégée par une capsule en résine, caractérisé en ce qu'il consiste :

-à découper sur une bande métallique continue - (20) des cellules conductrices successives (29), chaque cellule étant retenue à la bande par des parties métalliques étroites (23) notamment au niveau des contacts;

-à déposer un film plastique (1) sur une.première face de la bande conductrice (2);

-à fixer sur une plage centrale conductrice de chaque cellule au moins un microcircuit (4) relié aux contacts (C1 à C8) par des fils (6, 7);

-à déposer sur la deuxième face de la bande conductrice, au moins localement au-dessus du microcircuit, une résine de protection;

-à séparer par découpe chaque micromodule de ses voisins.

2. Procédé selon la revendication 1, caractérisé en ce qu'il consiste à réaliser à chaque pas de la bande métallique plusieurs cellules conductrices - (12, 13) afin d'augmenter le rendement de fabrication.

3. Procédé selon la revendication 1 ou 2, caractérisé en ce qu'il consiste à réaliser un dépôt d'un agent protecteur comme de l'or avant de fixer le microcircuit à la cellule.

4. Procédé selon la revendication 1 ou 2, caractérisé en ce qu'il consiste à réaliser des volets - (40-55) sur les parties conductrices de chaque cellule à l'intérieur de la zone (56) de dépose d'une résine. protectrice avant l'opération de dépôt de celle-ci.

5. Procédé selon la revendication 1, caractérisé en ce qu'il consiste à détacher le film plastique avant la découpe de chaque micromodule.

6. Procédé selon la revendication 1, caractérisé en ce que la découpe des parties conductrices de chaque cellule est réalisée par estampage.

7. Procédé selon la revendication 1, caractérisé en ce que la découpe des parties conductrices de chaque cellule est réalisée par photogravure.

8. Bande continue de micromodules réalisée selon le procédé de l'invention, caractérisée en ce qu'elle comporte une première couche (1) constituée par un film plastique de protection des contacts des micromodules assemblés, une seconde couche conductrice (2) qui constitue une cellule conductrice (29) de contact pour chaque micromodule (1) et les éléments de retenue de chaque micromodule à ses voisins, une troisième couche - (3) constituée par une résine de protection, au moins un microcircuit (4) ayant été déposé sur chaque cellule avec ses connexions (6, 7) avant dépôt de la troisième couche (3).

9. Bande selon la revendication 8, caractérisée en ce qu'elle comporte aussi des moyens (25-28) d'indexation pour permettre sa manipulation.

10. Bande selon la revendication 8, caractérisée en ce que les moyens d'indexation sont constitués par des perçages répartis périodiquement à chaque pas de micromodules - (29).

11. Bande selon la revendication 8, caractérisée en ce que les moyens d'indexation sont constitués par des perçages disposés aux extrêmités longitudinales de la bande.

12. Micromodule découpé dans une bande de micromodules selon l'une des revendications 8 à 11, caractérisé en ce qu'il comporte successivement un film plastique protecteur (1) détachable au moins localement au droit des contacts (C1-C8), une cellule conductrice (29) constituant les contacts et un support (S1) d'au moins un microcircuit (4) relié par des fils de connexion électrique (6,7) aux contacts (C1 à C8) et une capsule (3) de résine recouvrant au moins partiellement (31) la face de la cellule qui porte le microcircuit.

13. Micromodule selon la revendication 12, caractérisé en ce qu'il comporte des volets (40, 55) rabattus à l'intérieur de la capsule de résine.

14. Micromodule selon la revendication 12, caractérisé en ce que les volets sont dressés perpendiculairement au plan de la cellule conductrice.

# FIG_1

# FIG_2

# FIG_3

0 211 716

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| Y | FR-A-2 337 381  (HONEYWELL BULL) <br> * Figures  5,6,11; revendication 22 * | 1 | H 01 L   23/48 <br> H 01 L   21/60 |
| X | | 8 | |
| | --- | | |
| Y | GB-A-2 073 947  (PHILIPS EL. AND ASSOC. IND.) <br> * Revendication 1 * | 1 | |
| A | | 6,9,10 | |
| | --- | | |
| Y | GB-A-2 149 209  (GAO) <br> * Figure 2; page 2, lignes  13-58 * | 1 | |
| A | | 5,12 | |
| | --- | | |
| A | US-A-2 985 806  (PHILCO) <br><br> * Figure 1 * | 4,13, 14 | |
| | --- | | |
| A | PATENTS ABSTRACTS OF JAPAN, vol. 8, no. 139 (E-253)[1576], 28 juin 1984; & JP - A - 59 47 748 (HITACHI SEISAKUSHO K.K.) 17-03-1984 <br> * Résumé * | 4,13, 14 | |
| | ---                    -/- | | |

**DOMAINES TECHNIQUES RECHERCHES (Int. Cl.4)**

H 01 L

Le présent rapport de recherche a été établi pour toutes les revendications

| Lieu de la recherche | Date d'achèvement de la recherche | Examinateur |
|---|---|---|
| LA HAYE | 23-09-1986 | DE RAEVE R.A.L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82

## DOCUMENTS CONSIDERES COMME PERTINENTS

Page 2

| Catégorie | Citation du document avec indication, en cas de besoin, des parties pertinentes | Revendication concernée | CLASSEMENT DE LA DEMANDE (Int. Cl.4) |
|---|---|---|---|
| A | FR-A-2 216 750 (RAFI)<br><br>----- | | |

DOMAINES TECHNIQUES RECHERCHES (Int. Cl.4)

Le présent rapport de recherche a été établi pour toutes les revendications

| Lieu de la recherche | Date d'achèvement de la recherche | Examinateur |
|---|---|---|
| LA HAYE | 23-09-1986 | DE RAEVE R.A.L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03.82